# EUROPEAN PATENT APPLICATION

(11) **EP 4 574 917 A1**
(43) Date of publication of application: **25.06.2025**
(21) Application number: 23864691.3
(22) Date of filing: 12.09.2023
(51) Int. Cl.: C09J 163/00, C08L 63/00, C09J 11/04, H01L 23/29

(54) **RESIN COMPOSITION AND USE THEREOF**

(30) Priority: 15.09.2022 CN 202211119850
(71) Applicant: Huawei Technologies Co., Ltd., Shenzhen, Guangdong 518129 (CN)
(72) Inventor: ZENG, Zhixiong, Shenzhen, Guangdong 518129 (CN); LIU, Chengjie, Shenzhen, Guangdong 518129 (CN); YUAN, Can, Shenzhen, Guangdong 518129 (CN); JIN, Song, Shenzhen, Guangdong 518129 (CN); BAO, Xusheng, Shenzhen, Guangdong 518129 (CN); ZHOU, Huihui, Shenzhen, Guangdong 518129 (CN)
(74) Representative: Epping - Hermann - Fischer
(86) International application number: PCT/CN2023/118230
(87) International publication number: WO 2024/055959

(57) **Abstract**

Embodiments of this application provide a resin composition. The resin composition includes epoxy resin, a curing agent, and an inorganic filler. A cut-off particle size of the inorganic filler is 3 µm, D10 of the inorganic filler ranges from 0.1 µm to 0.4 µm, D50 ranges from 0.5 µm to 1.1 µm, and D90 ranges from 1.3 µm to 2.9 µm. The resin composition has a low viscosity and high fluidity, and has a good narrow gap filling capability. Embodiments of this application further provide application of the resin composition.

## Description

This application claims priority to Chinese Patent Application No. 202211119850.4, filed with the China National Intellectual Property Administration on September 15, 2022 and entitled "RESIN COMPOSITION AND APPLICATION THEREOF", which is incorporated herein by reference in its entirety.

### TECHNICAL FIELD

Embodiments of this application relate to the field of electronic component preparation technologies, and in particular, to a resin composition and application thereof.

### BACKGROUNDS

With continuous development of information technologies, entire electronic devices are developing towards miniaturization, portability, multi-function, digitization, high reliability, high performance, and the like. Therefore, internal components of the devices need to be miniaturized, integrated, and modularized. Based on this, advanced packaging forms such as a flip chip (Flip chip), fan-in wafer level packaging (Fan-in Wafer Level Packaging, FOWLP), fan-out wafer level packaging (Fan-Out Wafer Level Packaging, FOWLP), through silicon via (Through Silicon Via, TSV), 2.5D packaging, 3D packaging, and eWLB (Embedded Wafer Level Ball Grid Array, embedded wafer level ball grid array) packaging emerge. A packaging material (for example, an epoxy molding compound, a chip bonding adhesive, an underfill material, and a thermally conductive adhesive) is used to perform functions such as insulation, bonding, stress relief, and protection in these packaging forms, to ensure reliable running of a chip.

In the 2.5D and 3D advanced packaging, to increase a quantity of I/O interfaces (Input/Output interfaces, input/output interfaces) and shorten a signal transmission distance, a packaging gap becomes smaller (less than 40 µm) and a packaging interface becomes more complex. Therefore, the packaging material is required to have a narrow gap filling capability, to implement narrow gap filling.

### SUMMARY

In view of this, embodiments of this application provide a resin composition. The resin composition has a narrow gap filling capability, and can be used as a packaging material for packaging an electronic component, to resolve a problem of difficulty in narrow gap filling of an existing packaging material to some extent.

Specifically, a first aspect of embodiments of this application provides a resin composition. The resin composition includes epoxy resin, a curing agent, and an inorganic filler. A cut-off particle size of the inorganic filler is 3 µm, D10 of the inorganic filler ranges from 0.1 µm to 0.4 µm, D50 ranges from 0.5 µm to 1.1 µm, and D90 ranges from 1.3 µm to 2.9 µm.

The resin composition provided in embodiments of this application is in a liquid state at room temperature, is a liquid resin composition, and is specifically a liquid epoxy resin composition. According to the resin composition, the inorganic filler with the cut-off particle size of 3 µm is selected, and D10, D50, and D90 of the inorganic filler are controlled to be within specific size ranges. The inorganic filler has a small cut-off particle size, and due to control on specific particle size distribution, the resin composition still has a low viscosity and high fluidity when a large quantity of inorganic fillers with small particle sizes are added, so that the resin composition finally has a good narrow gap packaging and filling capability. The resin composition is used as an underfill material to be filled between an electronic component (for example, a chip), a soldering bump, and a substrate to form an underfill adhesive layer, so that a requirement for filling a narrow packaging gap less than 40 µm can be met, generation of an air hole during underfilling can also be better avoided, and settlement of the inorganic filler is prevented. In this way, the formed underfill adhesive layer has high uniformity, thereby improving packaging reliability, improving service reliability of the electronic component, and better matching an increasingly narrow and complex narrow gap packaging application requirement in the electronic packaging field. The underfill adhesive layer may disperse stress borne on a surface of the electronic component, alleviate an internal stress problem caused by mismatch of coefficients of thermal expansion CTE of the chip, the soldering bump, and the substrate, protect the soldering bump, and ensure reliable running of the electronic component.

In an implementation of this application, D10 of the inorganic filler ranges from 0.2 µm to 0.3 µm, D50 ranges from 0.6 µm to 10 µm, and D90 ranges from 1.5 µm to 2.7 µm. D10, D50, and D90 of the inorganic filler are controlled to be within the foregoing specific size ranges, so that the resin composition still has a low viscosity and high fluidity when a large quantity of inorganic fillers with small particle sizes are added, a narrow gap packaging and filling capability of the resin composition is improved, generation of an air hole during underfilling can also be better avoided, and settlement of the inorganic filler is prevented. In this way, the formed underfill adhesive layer has higher uniformity, thereby improving packaging reliability, and improving service reliability of the electronic component.

In an implementation of this application, a granularity distribution coefficient P of the inorganic filler satisfies P=(D90-D10)/D50≤3.5. Proper control of the granularity distribution coefficient helps better improve a narrow gap packaging and filling capability of a resin composition system.

In an implementation of this application, a specific surface area of the inorganic filler ranges from 2 m²/g to 10 m²/g. The specific surface area of the inorganic filler is controlled to be within a proper range, so that interaction between the inorganic filler and the epoxy resin can be enhanced, and inorganic filler can be better prevented from settlement. In this way, the inorganic filler and the epoxy resin in the underfill adhesive layer formed when the resin composition is used for underfilling are distributed more evenly, thereby making performance of the underfill adhesive layer more uniform, and finally improving packaging reliability and service reliability of the electronic component.

In an implementation of this application, the inorganic filler includes one or more of silicon dioxide, aluminum oxide, magnesium oxide, aluminum nitride, and silicon nitride. Addition of the inorganic filler can reduce a coefficient of thermal expansion of the resin composition system, reduce thermal stress, further reduce water absorption, reduce molding shrinkage, reduce resin overflow, improve a mechanical property, improve a thermal deformation temperature, and enhance wear resistance.

In an implementation of this application, the inorganic filler is a spherical particle with a sphericity greater than 98%. A spherical particle inorganic filler with a high sphericity is selected to be added to the resin composition, so that fluidity of the resin composition can be improved, a narrow gap filling capability can be enhanced, and underfilling of a large-sized chip can be better satisfied.

In an implementation of this application a mass fraction of the inorganic filler in the resin composition is greater than or equal to 55%. Content of the inorganic filler is controlled to be high, so that a coefficient of thermal expansion of a cured product of the resin composition is reduced, and thermal stress is reduced, thereby improving packaging reliability.

In an implementation of this application the mass fraction of the inorganic filler in the resin composition ranges from 55% to 80%. The inorganic filler is controlled to be within a proper high content range, so that the resin composition can better balance a low coefficient of thermal expansion, a high glass conversion temperature Tg, a low viscosity, and a proper mechanical property, thereby ensuring that the resin composition can be used as the underfill material to implement narrow gap underfilling, and improving packaging reliability.

In an implementation of this application, the epoxy resin includes one or more of glycidyl ether epoxy resin, glycidyl ester epoxy resin, glycidyl amine epoxy resin, aliphatic epoxy resin, bisphenol F epoxy resin, naphthalene epoxy resin, aminophenol epoxy resin, binaphthalene epoxy resin, bisphenol A epoxy resin, and phenolic epoxy resin. In the resin composition, there may be one type of epoxy resin, or there may be a combination of a plurality of (two or more) types of epoxy resin.

Because the chip processes more and more signals, an operating junction temperature increases accordingly. Especially when a device is switched on or off, an instantaneous temperature is higher, and the chip junction temperature may be greater than the glass transition temperature Tg of the packaging material. In this case, the packaging material is softened, and the chip fails. To better increase the glass transition temperature Tg of the cured product of the resin composition, in an implementation of this application, the epoxy resin includes multifunctional epoxy resin. The multifunctional (three-functional and above) epoxy resin and the curing agent are cross-linked, to increase a cross-linking density of the entire cured product, and increase the glass transition temperature Tg of the cured product of the resin composition, thereby improving packaging reliability, effectively avoiding a chip failure problem, and improving reliability of a high junction temperature chip.

In an implementation of this application, a mass fraction of the curing agent in the resin composition ranges from 5% to 20%. Proper curing agent content can enable the epoxy resin to be cured smoothly, to obtain basic material properties that meet packaging.

In an implementation of this application, a mass fraction of the epoxy resin in the resin composition ranges from 15% to 30%. Proper epoxy resin content may enable the resin composition to meet basic material properties of packaging, to implement filling, and can better ensure a strong combination between the chip, the soldering bump, and the substrate.

In an implementation of this application, the curing agent includes an amine curing agent and/or an anhydride curing agent. In an implementation of this application, the anhydride curing agent may be one or more of hexahydrophthalic anhydride, tetrahydrophthalic anhydride, methyltetrahydrophthalic anhydride, methylhexahydrophthalic anhydride, hexahydrophthalic anhydride, alkyl hexahydrophthalic anhydride, tetrahydrophthalic anhydride, succinic anhydride, methyl nadic anhydride, hydrogenated methylnadic anhydride, 5-norbornene-2,3-dicarboxylic anhydride, trialkyl tetrahydrophthalic anhydride, and the like. In an implementation of this application, the amine curing agent may be an aromatic amine curing agent, or may be a fatty amine curing agent. Specifically, the amine curing agent may be diethyltoluene diamine, polyetheramine, isophorone diamine, 3,3'-dimethyl-4,4'-diamino-dicyclohexylmethane, or the like.

In an implementation of this application, to improve performance of the resin composition, the resin composition may further include an additive, and the additive includes one or more of a coupling agent, a toughening agent, a stress modifier, a curing accelerator, a colorant, a dispersant, an ion trapping agent, a defoamer, a leveling agent, a flame retardant, a mold release agent, and a flow improver. The additive may be added according to a specific requirement.

In an implementation of this application, a viscosity of the resin composition at 110°C is less than 0.3 Pa.s. The resin composition has a low viscosity. This helps ensure that the resin composition has good fluidity and filling performance during packaging and filling, thereby better meeting a narrow gap filling requirement and improving packaging effect.

In an implementation of this application, the glass transition temperature of the cured product of the resin composition is greater than or equal to 145°C. After being cured, the resin composition has a high glass transition temperature Tg, which can improve service reliability of an adhesive layer obtained through packaging, and effectively avoid a chip failure problem.

In an implementation of this application, the coefficient of thermal expansion of the cured product of the resin composition ranges from 25 ppm/°C to 35 ppm/°C. A low coefficient of thermal expansion helps improve packaging reliability.

A second aspect of embodiments of this application provides a packaging material, used for sealed packaging (that is, packaging) of an electronic component. The packaging material includes the resin composition according to the first aspect of embodiments of this application and/or a cured product of the resin composition. The resin composition provided in embodiments of this application is used as the packaging material (that is, an electronic packaging material), and is used for packaging the electronic component, so that packaging effect can be improved, and service reliability of an electronic device can be improved.

A third aspect of embodiments of this application provides application of the resin composition according to the first aspect in sealed packaging of an electronic component, that is, application of the resin composition as an electronic packaging material in the electronic packaging field.

In an implementation of this application, the application of the resin composition in sealed packaging of the electronic component may include application of the resin composition as an underfill material in sealed packaging of the electronic component. Specifically, the resin composition is filled between a substrate and the electronic component, and a solid filling layer is formed after heating and curing. This can reduce stress impact caused by a difference between coefficients of thermal expansion of the electronic component and the substrate, improve strength and connection reliability of a packaging structure, and enhance overall anti-drop performance of the packaging structure.

A fourth aspect of embodiments of this application provides a cured product. The cured product includes a cured product of the resin composition according to the first aspect of embodiments of this application. The cured product in this embodiment of this application may be filled between a substrate and an electronic component, and is specifically located between a soldering bump that connects the substrate and the electronic component.

A fifth aspect of embodiments of this application provides a packaged device. The packaged device includes the cured product according to the fourth aspect of embodiments of this application. The packaged device in this embodiment of this application is packaged by using the cured product of the resin composition provided in embodiments of this application, and has high service reliability.

In an implementation of this application, the packaged device includes a substrate and an electronic component disposed on the substrate, a plurality of soldering bumps are disposed on a surface of one side that is of the electronic component and that faces the substrate, an underfill adhesive layer is disposed between the soldering bumps, and the underfill adhesive layer includes the cured product. In an implementation of this application, the packaged device further includes a molded body covering a surface of the electronic component. In this application, the electronic component includes but is not limited to a chip. When the electronic component is the chip, the packaged device is in a chip packaged structure.

An embodiment of this application further provides a terminal device. The terminal device includes a circuit board and the packaged device according to the fifth aspect of embodiments of this application that is disposed on the circuit board. The terminal device in this embodiment of this application uses the packaged device provided in embodiments of this application, so that service reliability of the terminal device can be improved.

An embodiment of this application further provides a communication device. The communication device includes the packaged device according to the fifth aspect of embodiments of this application.

An embodiment of this application further provides a communication base station. The communication base station includes the packaged device according to the fifth aspect of embodiments of this application.

### BRIEF DESCRIPTION OF DRAWINGS

FIG. 1 is a diagram of a structure of a packaged device 100 according to an embodiment of this application;
FIG. 2 is a diagram of a packaged device 100 disposed on a circuit board according to an embodiment of this application; and
FIG. 3 is a diagram of a structure of a terminal device 200 according to an embodiment of this application.

### DESCRIPTION OF EMBODIMENTS

The following describes embodiments of this application with reference to accompanying drawings in embodiments of this application.

A solid underfill adhesive layer is formed by filling a packaging material between a substrate and a chip after being heated and being cured. This can reduce stress impact caused by a difference between coefficients of thermal expansion of the chip and the substrate, to protect the chip, the substrate, and a soldering bump, improve strength and connection reliability of a packaging structure, and enhance overall anti-drop performance of the packaging structure. However, in a current advanced packaging structure, to increase a quantity of I/Os and shorten a signal transmission distance, a packaging gap becomes smaller (less than 40 µm) and a packaging interface becomes more complex. Therefore, the packaging material is required to have an excellent narrow gap filling capability, to better match an increasingly narrow and complex narrow gap packaging application requirement in the electronic packaging field. Based on this, embodiments of this application provide a resin composition. The resin composition is in a liquid state, and is a liquid packaging material. The resin composition has a good narrow gap packaging and filling capability. The resin composition may be applied to, but is not limited to, advanced packaging structures such as a flip chip (Flip chip), fan-in wafer level packaging FOWLP, fan-out wafer level packaging FOWLP, through silicon via TSV, 2.5D packaging, 3D packaging, and embedded wafer level ball grid array eWLB packaging.

Embodiments of this application provide a resin composition. The resin composition includes epoxy resin, a curing agent, and an inorganic filler. A cut-off particle size of the inorganic filler is 3 µm, D10 of the inorganic filler ranges from 0.1 µm to 0.4 µm, D50 ranges from 0.5 µm to 1.1 µm, and D90 ranges from 1.3 µm to 2.9 µm.

The cut-off particle size is a jammed particle size or a truncated particle size, and is a theoretical maximum particle size. However, due to a process limitation, some inorganic filler particles whose particle sizes exceed the cut-off particle size may inevitably exist in the inorganic filler, and specifically, there may be an inorganic filler particle whose particle size is greater than the cut-off particle size and whose magnitude is at a ppm level. For example, that a cut-off particle size of the inorganic filler is 3 µm means that the particle size of an inorganic filler is basically less than or equal to 3 µm, and a particle size of an inorganic filler greater than 3 µm is at the ppm level.

The resin composition provided in embodiments of this application is in a liquid state at room temperature, is a liquid resin composition, and is specifically a liquid epoxy resin composition. According to the resin composition, the inorganic filler with the cut-off particle size of 3 µm is selected, and D10, D50, and D90 of the inorganic filler are controlled to be within specific size ranges. The inorganic filler has a small cut-off particle size, and due to control on specific particle size distribution, the resin composition still has a low viscosity and high fluidity when a large quantity of inorganic fillers with small particle sizes are added, so that the resin composition finally has a good narrow gap packaging and filling capability. The resin composition is used as an underfill material to be filled between an electronic component (for example, a chip), a soldering bump, and a substrate to form an underfill adhesive layer, so that a requirement for filling a narrow packaging gap less than 40 µm can be met, generation of an air hole during underfilling can also be better avoided, and settlement of the inorganic filler is prevented. In this way, the formed underfill adhesive layer has high uniformity, thereby improving packaging reliability, improving service reliability of the electronic component, and better matching an increasingly narrow and complex narrow gap packaging application requirement in the electronic packaging field. The underfill adhesive layer may disperse stress borne on a surface of the electronic component, alleviate an internal stress problem caused by mismatch of coefficients of thermal expansion CTE of the chip, the soldering bump, and the substrate, protect the soldering bump, and ensure reliable running of the electronic component.

In an implementation of this application, D10 of the inorganic filler ranges from 0.1 µm to 0.4 µm, D50 ranges from 0.5 µm to 1.1 µm, and D90 ranges from 1.2 µm to 2.9 µm. Specifically, D10 may be, for example, 0.1 µm, 0.2 µm, 0.3 µm, or 0.4 µm. D50 may be, for example, 0.5 µm, 0.6 µm, 0.7 µm, 0.8 µm, 0.9 µm, 1.0 µm, or 1.1 µm. D90 may be, for example, 1.3 µm, 1.4 µm, 1.5 µm, 1.6 µm, 1.7 µm, 1.8 µm, 1.9 µm, 2.0 µm, 2.1 µm, 2.2 µm, 2.3 µm, 2.4 µm, 2.5 µm, 2.6 µm, 2.7 µm, 2.8 µm, or 2.9 µm. In some embodiments, D10 of the inorganic filler ranges from 0.2 µm to 0.3 µm, D50 ranges from 0.6 µm to 1.0 µm, and D90 ranges from 1.5 µm to 2.7 µm. D10, D50, and D90 are particle sizes when accumulated granularity distribution reaches 10%, 50%, and 90% respectively. D10, D50, and D90 of the inorganic filler are controlled to be within the foregoing specific size ranges, so that the resin composition still has a low viscosity and high fluidity when a large quantity of inorganic fillers with small particle sizes are added, a narrow gap packaging and filling capability of the resin composition is improved, generation of an air hole during underfill can also be better avoided, and settlement of the inorganic filler is prevented. In this way, the formed underfill adhesive layer has higher uniformity, thereby improving packaging reliability, and improving service reliability of the electronic component.

It should be noted that, due to a limitation of a detection method and a detection instrument, a value of the particle size of the inorganic filler in this embodiment of this application may have an error allowed by the detection method or the detection instrument in the art.

In an implementation of this application, a granularity distribution coefficient P of the inorganic filler satisfies P=(D90-D10)/D50≤3.5. In some implementations, the granularity distribution coefficient P of the inorganic filler ranges from 1 to 3.5. Specifically, the granularity distribution coefficient P of the inorganic filler may be, for example, 1, 1.5, 2, 2.3, 2.5, 2.7, 3, or 3.5. Proper control of the granularity distribution coefficient helps better improve a narrow gap packaging and filling capability of a resin composition system.

In an implementation of this application, a specific surface area of the inorganic filler ranges from 2 m²/g to 10 m²/g. A specific surface area is a total area of a material of unit mass. In an implementation of this application, the specific surface area of the inorganic filler may be specifically 2 m²/g, 3 m²/g, 4 m²/g, 5 m²/g, 6 m²/g, 7 m²/g, 8 m²/g, 9 m²/g, or 10 m²/g. The specific surface area of the inorganic filler is controlled to be within a proper range, so that interaction between the inorganic filler and the epoxy resin can be enhanced, and inorganic filler can be better prevented from settlement. In this way, the inorganic filler and the epoxy resin in the underfill adhesive layer formed when the resin composition is used for underfilling are distributed more evenly, thereby making performance of the underfill adhesive layer more uniform, and finally improving packaging reliability and service reliability of the electronic component.

In an implementation of this application, the inorganic filler may include one or more of silicon dioxide, aluminum oxide, magnesium oxide, aluminum nitride, and silicon nitride. Addition of the inorganic filler can reduce a coefficient of thermal expansion of the resin composition system, reduce thermal stress, further reduce water absorption, reduce molding shrinkage, reduce resin overflow, improve a mechanical property, improve a thermal deformation temperature, and enhance wear resistance, thereby improving packaging reliability of application of the resin composition used as a packaging material.

In an implementation of this application, the inorganic filler is a spherical particle with a sphericity greater than 98%. A spherical particle inorganic filler with a high sphericity is selected to be added to the resin composition, so that fluidity of the resin composition can be improved, a narrow gap filling capability can be enhanced, and underfilling of a large-sized chip can be better satisfied.

In some implementations of this application, the inorganic filler is spherical silicon dioxide. The spherical silicon dioxide is used to better improve fluidity and a coefficient of thermal expansion of the resin composition.

In an implementation of this application, the cut-off particle size of the inorganic filler may be measured by using a scanning electron microscope (scanning electron microscope, SEM) or the like, and particle size distribution of the inorganic filler may be analyzed by using a dynamic light scattering granulometer.

In an implementation of this application, a mass fraction of the inorganic filler in the resin composition is greater than or equal to 55%. Content of the inorganic filler is controlled to be high, so that a coefficient of thermal expansion of a cured product of the resin composition is reduced, and thermal stress is reduced, thereby improving packaging reliability.

In an implementation of this application, the mass fraction of the inorganic filler in the resin composition ranges from 55% to 80%. In some embodiments of this application, the mass fraction of the inorganic filler in the resin composition is 55%, 56%, 57%, 58%, 59%, 60%, 61%, 62%, 63%, 64%, 65%, 66%, 67%, 68%, 69%, 70%, 71%, 72%, 75%, or 80%. The inorganic filler is controlled to be within a proper high content range, so that the resin composition can better balance a low coefficient of thermal expansion, a high glass conversion temperature Tg, a low viscosity, and a proper mechanical property, thereby ensuring that the resin composition can be used as the underfill material to implement narrow gap underfilling, and improving packaging reliability.

In an implementation of this application, the epoxy resin may include one or more of glycidyl ether epoxy resin, glycidyl ester epoxy resin, glycidyl amine epoxy resin, aliphatic epoxy resin, bisphenol F epoxy resin, naphthalene epoxy resin, aminophenol epoxy resin, binaphthalene epoxy resin, bisphenol A epoxy resin, and phenolic epoxy resin. In the resin composition, there may be one type of epoxy resin, or there may be a combination of a plurality of (two or more) types of epoxy resin. In some implementations of this application, the epoxy resin includes one or more of the bisphenol F epoxy resin, the aminophenol epoxy resin, the bisphenol A epoxy resin, the naphthalene epoxy resin, or the binaphthalene epoxy resin.

In an implementation of this application, types of the epoxy resin and types of the curing agent may be obtained by using methods such as a nuclear magnetic resonance spectrograph or an infrared spectrometer, or through element analysis.

Because the chip processes more and more signals, an operating junction temperature increases accordingly. Especially when a device is switched on or off, an instantaneous temperature is higher and, the chip junction temperature may be greater than the glass transition temperature Tg of the packaging material. In this case, the packaging material is softened, and the chip fails. To better increase the glass transition temperature Tg of the cured product of the resin composition, in an implementation of this application, the epoxy resin includes multifunctional epoxy resin. The multifunctional (three-functional and above) epoxy resin and the curing agent are cross-linked, to increase a cross-linking density of the entire cured product, and increase the glass transition temperature Tg of the cured product of the resin composition, thereby improving packaging reliability, effectively avoiding a chip failure problem, and improving reliability of a high junction temperature chip.

In an implementation of this application, a mass fraction of the curing agent in the resin composition ranges from 5% to 20%. In some embodiments of this application, the mass fraction of the curing agent in the resin composition may be 5%, 6%, 7%, 8%, 9%, 10%, 11%, 12%, 13%, 14%, 15%, 16%, 17%, 18%, 19%, or 20%. Proper curing agent content can enable the epoxy resin to be cured smoothly, to obtain basic material properties that meet packaging.

In an implementation of this application, a mass fraction of the epoxy resin in the resin composition ranges from 15% to 30%. In some embodiments of this application, the mass fraction of the epoxy resin in the resin composition may be 15%, 16%, 17%, 18%, 19%, 20%, 21%, 22%, 23%, 24%, 25%, 26%, 27%, 28%, 29%, or 30%. Proper epoxy resin content may enable the resin composition to meet basic material properties of packaging, to implement filling, and can better ensure a strong combination between the chip, the soldering bump, and the substrate.

In an implementation of this application, the curing agent may include an amine curing agent and/or an anhydride curing agent. In an implementation of this application, the anhydride curing agent may be one or more of hexahydrophthalic anhydride, tetrahydrophthalic anhydride, methyltetrahydrophthalic anhydride, methylhexahydrophthalic anhydride, hexahydrophthalic anhydride, alkyl hexahydrophthalic anhydride, tetrahydrophthalic anhydride, succinic anhydride, methyl nadic anhydride, hydrogenated methylnadic anhydride, 5-norbornene-2,3-dicarboxylic anhydride, trialkyl tetrahydrophthalic anhydride, and the like. In an implementation of this application, the amine curing agent may be an aromatic amine curing agent, or may be a fatty amine curing agent. Specifically, the amine curing agent may be one or more of diethyltoluene diamine, polyetheramine, isophorone diamine, 3,3'-dimethyl-4,4'-diamino-dicyclohexylmethane, and the like. The amine curing agent has lower water absorption, which is conducive to reducing water absorption of the cured product of the resin composition. The resin composition in this application may include one curing agent, or may include a plurality of (two or more) curing agents.

In an implementation of this application, to improve performance of the resin composition, the resin composition may further include an additive, and the additive includes but is not limited to one or more of a coupling agent, a toughening agent, a stress modifier, a curing accelerator, a colorant, a dispersant, an ion trapping agent, a defoamer, a leveling agent, a flame retardant, a mold release agent, and a flow improver. The additive may be added according to a specific requirement. In an implementation of this application, there is no special limitation on specific types of the coupling agent, the toughening agent, the stress modifier, the curing accelerator, the colorant, the dispersant, the ion trapping agent, the defoamer, the leveling agent, the flame retardant, the mold release agent, and the flow improver. The coupling agent includes but is not limited to one or more of γ-glycidyl ether oxypropyl trimethoxysilane, γ-aminopropyl triethoxysilane, γ-methylpropyl propyl oxypropyl trimethylsilane, 3-aminopropyl trimethyloxysilane, and N-(β-aminoethyl)-γ-aminopropyl trimethoxysilane. The curing accelerator includes but is not limited to one or more of tertiary amine (for example, N,N-dimethyl benzylamine), imidazole, and modified imidazole (for example, dimethylimidazole and 1-phenyl dimethylimidazole).

In an implementation of this application, a viscosity of the resin composition at 110°C is less than 0.3 Pa.s. The viscosity of the resin composition can be measured by a rheometer. In some implementations, the viscosity of the resin composition at 110°C is less than 0.25 Pa.s. In some implementations, the viscosity of the resin composition at 110°C is less than 0.2 Pa.s. In some implementations, the viscosity of the resin composition at 110°C is less than 0.15 Pa.s. The viscosity of the resin composition can be measured by a rheometer. It should be noted that the resin composition in this embodiment of this application needs to be stored and transported at a low temperature of -40°C or below. The viscosity refers to a viscosity measured after the resin composition is just prepared, or a viscosity measured after thawing. The resin composition has a low viscosity. This helps ensure that the resin composition has good fluidity and filling performance during packaging and filling, thereby better meeting a narrow gap filling requirement and improving packaging effect.

In an implementation of this application, the glass transition temperature of the cured product of the resin composition is greater than or equal to 145°C. In some implementations of this application, the glass transition temperature of the cured product of the resin composition is greater than or equal to 150°C. In some implementations of this application, the glass transition temperature of the cured product of the resin composition is greater than or equal to 160°C. In some implementations of this application, the glass transition temperature of the cured product of the resin composition is greater than or equal to 170°C. In some implementations of this application, the glass transition temperature of the cured product of the resin composition is greater than or equal to 180°C. After being cured, the resin composition has a high glass transition temperature Tg, which can improve service reliability of an adhesive layer obtained through packaging, and effectively avoid a chip failure problem.

In an implementation of this application, the coefficient of thermal expansion of the cured product of the resin composition ranges from 25 ppm/°C to 35 ppm/°C. Specifically, the coefficient of thermal expansion of the cured product of the resin composition may be, for example, 25 ppm/°C, 26 ppm/°C, 27 ppm/°C, 28 ppm/°C, 29 ppm/°C, 30 ppm/°C, 31 ppm/°C, 32 ppm/°C, 33 ppm/°C, 34 ppm/°C, or 35 ppm/°C. A low coefficient of thermal expansion helps improve packaging reliability.

The resin composition in this embodiment of this application may be prepared by stirring and mixing ingredients. The stirring and mixing may be performed by using a top-mounted mechanical stirrer, a dual-planetary mixer, a homogenizer, or a three-roll grinding machine alone, or may be performed by using a combination of the foregoing apparatuses.

The resin composition in this embodiment of this application is a liquid packaging material, and may be filled in a needle cylinder of 10ce, 30cc, or a larger volume for storage. The resin composition in this embodiment of this application needs to be stored and transported at a low temperature of -40°C or below.

The resin composition in this embodiment of this application is cured when being heated, and the epoxy resin and the curing agent in the resin composition may chemically react to form a three-dimensional mesh polymer. The resin composition is converted into a cured product of a specific shape after being cured, and the cured product may be a thin film, a sheet, or a three-dimensional structure. The resin composition in this application is usually in a liquid state. The liquid resin composition may be directly used as liquid glue, and may be coated, filled, and cured to form the adhesive layer.

The resin composition in this embodiment of this application is the epoxy resin composition including the inorganic filler, and the resin composition has a good narrow gap packaging and filling capability. The resin composition may be used as an underfill material to be filled between an electronic component (for example, a chip), a soldering bump, and a substrate to form an underfill adhesive layer, so that a requirement for filling a narrow packaging gap of 40 µm or less can be met, generation of an air hole during underfilling can also be better avoided, and settlement of the inorganic filler is prevented. In this way, the formed underfill adhesive layer has high uniformity, thereby improving packaging reliability, and improving service reliability of the electronic component. The resin composition may be applied to, but is not limited to, advanced packaging structures such as a flip chip (Flip chip), fan-in wafer level packaging FOWLP, fan-out wafer level packaging FOWLP, through silicon via TSV, 2.5D packaging, 3D packaging, and embedded wafer level ball grid array eWLB packaging. A product (such as a processor) using these advanced packaging structures may be used in an entire device, for example, a mobile phone, a computer, or an automobile. The resin composition in this application may be further applied to large-area molding, thin packaging without grinding, a passive device, POP (package-on-package, package-on-package technology) packaging, and the like. These packaged products may be used in devices such as wireless apparatuses and self-driving sensors of mobile electronic devices.

An embodiment of this application further provides a packaging material. The packaging material is an electronic packaging material, and is used for sealing packaging of an electronic component. The packaging material includes the resin composition provided in the foregoing embodiment of this application and/or a cured product of the resin composition provided in the foregoing embodiment of this application. The resin composition provided in embodiments of this application is used as the packaging material, and is used for packaging the electronic component, so that packaging effect can be improved, and service reliability of an electronic device can be improved.

This embodiment of this application provides application of the resin composition according to the first aspect in sealed packaging of an electronic component, that is, application of the resin composition as an electronic packaging material in the electronic packaging field, specifically, application in sealed packaging of the electronic component. In this embodiment of this application, the electronic component may be a chip, a transistor (such as a diode or a triode), an LED, a resistor-capacitor-inductor element (such as a resistor, a capacitor, or an inductor), or the like. Structure forms of packaging may be advanced packaging structures such as a flip chip (Flip chip), fan-in wafer level packaging FOWLP, fan-out wafer level packaging FOWLP, through silicon via TSV, 2.5D packaging, 3D packaging, and embedded wafer level ball grid array eWLB packaging, and may also be packaging structures such as large-area molding, thin packaging without grinding, passive device packaging, and POP (package-on-package, package-on-package technology) packaging.

In an implementation of this application, the application of the resin composition in sealed packaging of the electronic component may include application of the resin composition as an underfill material in sealed packaging of the electronic component. Specifically, the resin composition is filled between a substrate and the electronic component, and a solid filling layer is formed after heating and curing. This can reduce stress impact caused by a difference between coefficients of thermal expansion of the electronic component and the substrate, improve strength and connection reliability of a packaging structure, and enhance overall anti-drop performance of the packaging structure.

This embodiment of this application further provides a cured product. The cured product includes a cured product of the resin composition according to this embodiment of this application. The cured product in this embodiment of this application may be filled between a substrate and an electronic component, and is specifically located between a soldering bump that connects the substrate and the electronic component. The cured product may be a thin film, a sheet, a three-dimensional structure, or the like. The cured product has characteristics such as a low coefficient of thermal expansion CTE, a high glass transition temperature Tg, high mechanical strength, and low water absorption.

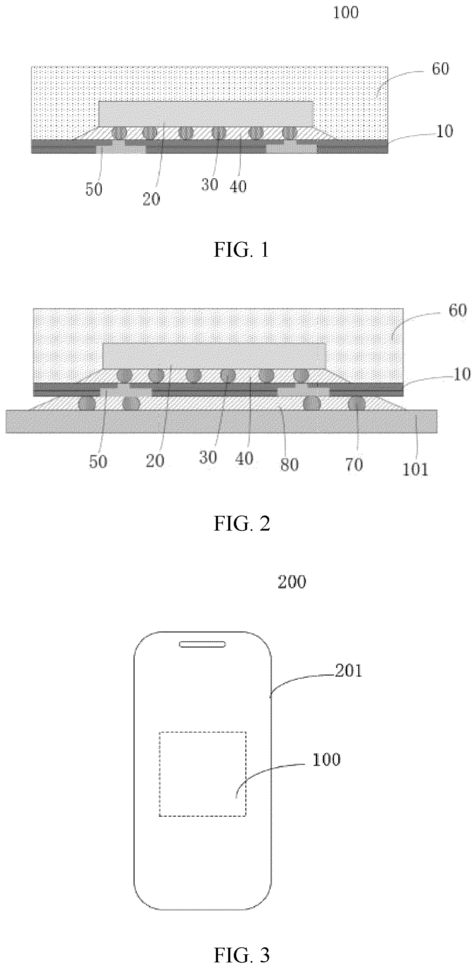

Refer to FIG. 1. An embodiment of this application further provides a packaged device 100. FIG. 1 is a diagram of a structure of the packaged device 100 according to an implementation of this application. The packaged device 100 may be a packaged device of an electronic device, and the packaged device 100 includes a cured product of the foregoing resin composition in embodiments of this application. Specifically, the packaged device 100 includes a substrate 10 and an electronic component 20 disposed on the substrate 10. A plurality of soldering bumps 30 are disposed on a surface of one side that is of the electronic component 20 and that faces the substrate 10. An underfill adhesive layer 40 is disposed between the soldering bumps 30, that is, between the substrate 10, the electronic component 20, and the soldering bump 30. The underfill adhesive layer 40 includes the cured product of the foregoing resin composition in embodiments of this application. In an implementation of this application, the packaged device 100 further includes a molded body 60 covering a surface of the electronic component 20 In an implementation of this application, the soldering bump 30 is electrically connected to the electronic component 20 via a conductive structure 50 in the substrate 10. The electronic component 20 may be various components that need to be packaged, and includes but is not limited to one or more of a chip, a transistor (such as a diode or a triode), an LED, and a resistor-capacitor-inductor element (such as a resistor, a capacitor, or an inductor). When the electronic component 20 is the chip, the packaged device 100 is in a chip packaged structure. The electronic component 20 may be attached to a surface of the substrate 10 through soldering, and the substrate 10 may be a redistribution layer (RDL). Refer to FIG. 2. The packaged device 100 may be soldered to a circuit board 101. A plurality of metal balls 70 may be disposed on a side that is of the substrate 10 and that is away from the electronic component 20. The electronic component 20 in the packaged device 100 may be electrically connected to the circuit board 101 via the conductive structure 50 and the metal balls 70. A filling adhesive layer 80 is disposed between the substrate 10, the circuit board 101, and the metal balls 70. The filling adhesive layer 80 may also be the cured product including the foregoing resin composition in embodiments of this application.

According to the packaged device 100 in this embodiment of this application, the resin composition provided in this embodiment of this application is used to package the electronic component, so that narrow gap filling can be implemented, process operability is high, and packaging reliability is high.

Refer to FIG. 3. An embodiment of this application further provides a terminal device 200. The terminal device 200 includes a housing 201, and a circuit board and a packaged device 100 that are disposed in the housing 201. Inside the terminal device 200, the packaged device 100 may be disposed on a circuit board 101 as shown in FIG. 2, and is electrically connected to the circuit board 101. The terminal device 200 may be a product, for example, a mobile phone, a tablet computer, a notebook computer, a portable computer, an intelligent wearable product, a television, a video recorder, a video camera recorder, a radio set, a radio-tape recorder, a vehicle-mounted terminal, a mouse, a keyboard, a microphone, or a scanner.

An embodiment of this application further provides a communication device. The communication device includes the foregoing packaged device 100 in embodiments of this application. The packaged device 100 may be electrically fastened to a circuit board. The communication device may be various wired communication devices or wireless communication devices, and includes but is not limited to a communication conversion device, a lightning arrester, an antenna, a gateway, a remote controller, a radar, a walkie-talkie, and a switch, a router.

An embodiment of this application further provides a communication base station. The communication base station includes the foregoing packaged device 100 in embodiments of this application. The packaged device 100 may be electrically fastened to a circuit board.

Embodiments of this application are further described below by using a plurality of embodiments.

### Embodiment 1

A resin composition is provided. The resin composition includes ingredients in the following mass fractions: trifunctional aminophenol epoxy resin: 26%; aromatic amine curing agent diethyl toluene diamine: 13%; inorganic filler A1: 60%; coupling agent γ-glycidyl ether oxypropyl trimethoxysilane: 1%, where the inorganic filler is spherical silicon dioxide with a cut-off particle size of 3 µm, D10 of 0.3 µm, D50 of 10 µm, D90 of 2.7 µm, and a specific surface area of 7 m²/g.

### Embodiment 2

A resin composition is provided. The resin composition includes ingredients in the following mass fractions: trifunctional aminophenol epoxy resin: 26%; aromatic amine curing agent diethyl toluene diamine: 13%; inorganic filler A2: 60%; coupling agent γ-glycidyl ether oxypropyl trimethoxysilane: 1%, where the inorganic filler is spherical silicon dioxide with a cut-off particle size of 3 µm, D10 of 0.2 µm, D50 of 0.8 µm, D90 of 2.4 µm, and a specific surface area of 7.6 m²/g.

### Embodiment 3

A resin composition is provided. The resin composition includes ingredients in the following mass fractions: trifunctional aminophenol epoxy resin: 26%; aromatic amine curing agent diethyl toluene diamine: 13%; inorganic filler A3: 60%; coupling agent γ-glycidyl ether oxypropyl trimethoxysilane: 1%, where the inorganic filler is spherical silicon dioxide with a cut-off particle size of 3 µm, D10 of 0.2 µm, D50 of 0.6 µm, D90 of 2.0 µm, and a specific surface area of 8 m²/g.

### Embodiment 4

A resin composition is provided. The resin composition includes ingredients in the following mass fractions: trifunctional aminophenol epoxy resin: 24.5%; aromatic amine curing agent diethyl toluene diamine: 9.5%; inorganic filler A1: 65%; coupling agent γ-glycidyl ether oxypropyl trimethoxysilane: 1%, where the inorganic filler is spherical silicon dioxide with a cut-off particle size of 3 µm, D10 of 0.3 µm, D50 of 10 µm, D90 of 2.7 µm, and a specific surface area of 7 m²/g.

### Embodiment 5

A resin composition is provided. The resin composition includes ingredients in the following mass fractions: trifunctional aminophenol epoxy resin: 22.5%; aromatic amine curing agent diethyl toluene diamine: 6.5%; inorganic filler A1: 70%; coupling agent γ-glycidyl ether oxypropyl trimethoxysilane: 1%, where the inorganic filler is spherical silicon dioxide with a cut-off particle size of 3 µm, D10 of 0.3 µm, D50 of 10 µm, D90 of 2.7 µm, and a specific surface area of 7 m²/g.

### Embodiment 6

A resin composition is provided. The resin composition includes ingredients in the following mass fractions: bisphenol F epoxy resin: 15%, trifunctional aminophenol epoxy resin: 10%; aromatic amine curing agent diethyl toluene diamine: 9%; inorganic filler A1: 65%; coupling agent γ-glycidyl ether oxypropyl trimethoxysilane: 1%, where the inorganic filler is spherical silicon dioxide with a cut-off particle size of 3 µm, D10 of 0.3 µm, D50 of 1.0 µm, D90 of 2.7 µm, and a specific surface area of 7 m²/g.

### Comparative example 1

A difference between Comparative example 1 and Embodiment 1 only lies in that an inorganic filler B1 is used, and the inorganic filler is spherical silicon dioxide with a cut-off particle size of 5 µm, D10 of 0.1 µm, D50 of 1.5 µm, D90 of 4.8 µm, and a specific surface area of 6 m²/g.

### Comparative example 2

A difference between Comparative example 2 and Embodiment 1 only lies in that an inorganic filler B2 is used, and the inorganic filler is spherical silicon dioxide with a cut-off particle size of 3 µm, D10 of 0.1 µm, D50 of 0.3 µm, D90 of 0.9 µm, and a specific surface area of 9 m²/g.

Formulas of Embodiment 1 to Embodiment 6, and Comparative example 1 and Comparative example 2 are listed in Table 1. A viscosity test and a flow length test are performed on the resin compositions prepared in Embodiment 1 to Embodiment 6 of this application, and the resin compositions in Comparative example 1 and Comparative example 2. A glass transition temperature Tg test is performed on cured products of the resin compositions prepared in Embodiment 1 to Embodiment 6 of this application, and cured products of the resin compositions of Comparative example 1 and Comparative example 2. A viscosity of the resin composition is measured by using a rheometer, and a viscosity at 110°C is measured at 50 rpm. The flow length of the resin composition is a flow length measured with a gap of 40 µm and at 110°C for 10 minutes. A glass transition temperature Tg of the cured product of the resin composition is measured by using a dynamic thermomechanical analyzer.

**Table 1 Summary of test results of Embodiments and Comparative examples**

| Ingredients and parameters | | Embodim ent 1 | Embodim ent 2 | Embodim ent 3 | Embodim ent 4 | Embodim ent 5 | Embodim ent 6 | Comparati ve example 1 | Comparati ve example 2 |
|---|---|---|---|---|---|---|---|---|---|
| Inorgan ic fillers | Inorganic filler A1 | 60 | | | 65 | 70 | 65 | | |
| | Inorganic filler A2 | | 60 | | | | | | |
| | Inorganic filler A3 | | | 60 | | | | | |
| | Inorganic filler B1 | | | | | | | 60 | |
| | Inorganic filler B2 | | | | | | | | 60 |
| Epoxy resin | Trifunctional aminophenol epoxy resin | 26 | 26 | 26 | 24.5 | 22.5 | 15 | 26 | 26 |
| | Bisphenol F epoxy resin | | | | | | 10 | | |
| Curing agent | Diethyltoluene diamine | 13 | 13 | 13 | 9.5 | 6.5 | 9 | 13 | 13 |
| Couplin g agent | γ-glycidyl ether oxypropyl trimethoxysilan e | 1 | 1 | 1 | 1 | 1 | 1 | 1 | 1 |
| Total weight ratio (%) | | 100 | 100 | 100 | 100 | 100 | 100 | 100 | 100 |
| Viscosity Pa.s (110°C) | | 0.11 | 0.12 | 0.13 | 0.14 | 0.17 | 0.17 | 0.18 | 0.25 |
| Tg (°C) | | 184 | 183 | 180 | 189 | 175 | 150 | 180 | 178 |
| Flow length (mm) | | 48 | 46 | 46 | 45 | 40 | 40 | 38 | 30 |

It can be learned from the results of Embodiment 1 to Embodiment 6 in Table 1 and Comparative example 1 and Comparative example 2 that, in Embodiment 1 to Embodiment 6 of this application, the spherical silicon dioxide with the cut-off particle size of 3 µm and D10, D50, and D90 in the specific size ranges is used as the filler, and the prepared resin composition can obtain a low viscosity and a narrow gap flow length greater than or equal to 40 mm. It indicates that the resin composition in this embodiment of this application has high fluidity and has a good narrow gap filling capability. However, in Comparative example 1, the spherical silicon dioxide with the cut-off particle size of 5 µm is used as the filler, and the resin composition has a high viscosity, and a flow length in a narrow gap is short, which is 38 mm. Although the cut-off particle size of 3 µm is used in Comparative example 2, D10 is 0.1 µm, D50 is 0.3 µm, and D90 is 0.9 µm. The resin composition has a high viscosity, and a flow length in a narrow gap is short, which is 30 mm.

In addition, it can be learned from Embodiment 1 to Embodiment 6 that, the glass transition temperature Tg of the resin composition system may be increased by using the multifunctional epoxy resin. It can be learned from Embodiment 1 to Embodiment 6 that, the low viscosity and high fluidity may be obtained by controlling the mass fraction of the inorganic filler in the resin composition within the proper range.

The resin compositions of Embodiment 1 to Embodiment 6 of this application and Comparative example 1 and Comparative example 2 are used to fill a bottom of a chip with a size of 25 mm*25 mm. A filling adhesive layer is represented through ultrasonic scanning, and the underfill adhesive layer is observed by using a scanning electron microscope after slicing. A result shows that the resin compositions in Embodiment 1 to Embodiment 6 of this application can completely fill a gap of 40 µm or less, and filling efficiency is high. In addition, the underfill adhesive layer has no bubble, and no filler settles. However, the resin composition in Comparative example 1 has low filling efficiency, it takes longer time than the resin compositions in Embodiment 1 to Embodiment 6 to implement complete filling, and the underfill adhesive layer has settlement of the inorganic filler. The resin composition of Comparative example 2 cannot be fully filled.

It should be understood that "first", "second", and various numbers in this specification are merely used for differentiation for ease of description, but are not intended to limit the scope of this application.

In this application, "and/or" describes an association relationship between associated objects, and indicates that three relationships may exist. For example, A and/or B may indicate that: only A exists, both A and B exist, and only B exists, where A and B may be singular or plural. The character "/" generally indicates an "or" relationship between the associated objects.

In this application, at least one means one or more, and a plurality of means two or more. "At least one of the following items (pieces)" or a similar expression thereof means any combination of these items, including a single item (piece) or any combination of a plurality of items (pieces). For example, "at least one of a, b, or c", or "at least one of a, b, and c" may indicate: a, b, c, a-b (namely, a and b), a-c, b-c, or a-b-c, where a, b, and c may be singular or plural.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A resin composition, wherein the resin composition comprises epoxy resin, a curing agent, and an inorganic filler, a cut-off particle size of the inorganic filler is 3 µm, D10 of the inorganic filler ranges from 0.1 µm to 0.4 µm, D50 ranges from 0.5 µm to 1.1 µm, and D90 ranges from 1.3 µm to 2.9 µm.

2. The resin composition according to claim 1, wherein D10 of the inorganic filler ranges from 0.2 µm to 0.3 µm, D50 ranges from 0.6 µm to 10 µm, and D90 ranges from 1.5 µm to 2.7 µm.

3. The resin composition according to claim 1, wherein a granularity distribution coefficient P of the inorganic filler satisfies P=(D90-D10)/D50≤3.5.

4. The resin composition according to any one of claims 1 to 3, wherein a specific surface area of the inorganic filler ranges from 2 m²/g to 10 m²/g.

5. The resin composition according to any one of claims 1 to 4, wherein the inorganic filler comprises one or more of silicon dioxide, aluminum oxide, magnesium oxide, aluminum nitride, and silicon nitride.

6. The resin composition according to any one of claims 1 to 5, wherein the inorganic filler is a spherical particle with a sphericity greater than 98%.

7. The resin composition according to any one of claims 1 to 6, wherein a mass fraction of the inorganic filler in the resin composition is greater than or equal to 55%.

8. The resin composition according to any one of claims 1 to 7, wherein the mass fraction of the inorganic filler in the resin composition ranges from 55% to 80%.

9. The resin composition according to any one of claims 1 to 8, wherein the epoxy resin comprises one or more of glycidyl ether epoxy resin, glycidyl ester epoxy resin, glycidyl amine epoxy resin, aliphatic epoxy resin, bisphenol F epoxy resin, naphthalene epoxy resin, aminophenol epoxy resin, binaphthalene epoxy resin, bisphenol A epoxy resin, and phenolic epoxy resin.

10. The resin composition according to claim 9, wherein the epoxy resin comprises multifunctional epoxy resin.

11. The resin composition according to any one of claims 1 to 10, wherein a mass fraction of the curing agent in the resin composition ranges from 5% to 20%.

12. The resin composition according to any one of claims 1 to 11, wherein a mass fraction of the epoxy resin in the resin composition ranges from 15% to 30%.

13. The resin composition according to any one of claims 1 to 12, wherein the curing agent comprises an amine curing agent and/or an anhydride curing agent.

14. The resin composition according to any one of claims 1 to 13, wherein the resin composition further comprises an additive, and the additive comprises one or more of a coupling agent, a toughening agent, a stress modifier, a curing accelerator, a colorant, a dispersant, an ion trapping agent, a defoamer, a leveling agent, a flame retardant, a mold release agent, and a flow improver.

15. The resin composition according to any one of claims 1 to 14, wherein a viscosity of the resin composition at 110°C is less than 0.3 Pa.s.

16. The resin composition according to any one of claims 1 to 15, wherein a glass transition temperature of a cured product of the resin composition is greater than or equal to 145°C.

17. The resin composition according to any one of claims 1 to 16, wherein a coefficient of thermal expansion of the cured product of the resin composition ranges from 25 ppm/°C to 35 ppm/°C.

18. A packaging material, used for sealed packaging of an electronic component, wherein the packaging material comprises the resin composition according to any one of claims 1 to 17 and/or a cured product of the resin composition.

19. Application of the resin composition according to any one of claims 1 to 17 in sealed packaging of an electronic component.

20. The application according to claim 19, wherein the application of the resin composition in the sealed packaging of the electronic component comprises using the resin composition as an underfill material.

21. A cured product, wherein the cured product comprises a cured product of the resin composition according to any one of claims 1 to 17.

22. A packaged device, wherein the packaged device comprises the cured product according to claim 21.

23. The packaged device according to claim 22, wherein the packaged device comprises a substrate and an electronic component disposed on the substrate, a plurality of soldering bumps are disposed on a surface of one side that is of the electronic component and that faces the substrate, an underfill adhesive layer is disposed between the soldering bumps, and the underfill adhesive layer comprises the cured product.

24. A terminal device, wherein the terminal device comprises a circuit board and the packaged device according to claim 22 or 23 that is disposed on the circuit board.

25. A communication device, wherein the communication device comprises the packaged device according to claim 22 or 23.

26. A communication base station, wherein the communication base station comprises the packaged device according to claim 22 or 23.
